# EUROPEAN PATENT APPLICATION

(11) **EP 2 908 334 A1**
(43) Date of publication of application: **19.08.2015**
(21) Application number: 13845086.1
(22) Date of filing: 12.09.2013
(51) Int. Cl.: H01L 21/56

(54) **SEMICONDUCTOR DEVICE AND METHOD FOR MANUFACTURING SAME**

(30) Priority: 12.10.2012 JP 2012227206
(71) Applicant: Sumitomo Electric Industries, Ltd., Osaka 541-0041 (JP)
(72) Inventor: NOTSU Hiroshi, Osaka-shi Osaka 554-0024 (JP)
(74) Representative: Grünecker Patent- und Rechtsanwälte PartG mbB
(86) International application number: PCT/JP2013/074712
(87) International publication number: WO 2014/057765

(57) **Abstract**

A semiconductor device which can improve its reliability and a method for manufacturing the same are provided. A semiconductor device (10) in accordance with one embodiment comprises a semiconductor element (12), a substrate (20), a case (40), and a sealant injection path (50). The semiconductor element (12) is mounted to the substrate (20). The case (40) contains the substrate (20) and allows a sealant to be injected therein for sealing the semiconductor element (12) to the inside. The sealant injection path (50) is formed in the case (40) and used for injecting the sealant into the case (40). In the sealant injection path (50), an injection port within the case (40) for the sealant is located on the substrate (20) side of an injection region (44) of the sealant within the case (40).

## Description

### Technical Field

The present invention relates to a semiconductor device and a method for manufacturing the same.

### Background Art

Known as examples of semiconductor devices include those of a case type (see Non Patent Literature 1). In such a semiconductor device, a semiconductor element mounted on an element mount substrate and contained in a case is connected to an electrode terminal through a wire. The semiconductor element and wire are insulatingly sealed with a gelled sealant injected into the case.

### Citation List

### Non Patent Literature

Non Patent Literature 1: Causes of Failures and Techniques for Improving and Evaluating Reliability of Wire Bonding Focused on Cu Wires, Technical Information Institute Co., Ltd., July 29, 2011, p. 163.

### Summary of Invention

### Technical Problem

When injecting the sealant into the case, bubbles may occur in a sealing part constructed by the sealant. If the bubbles remain within the sealing part, heat occurring in the semiconductor element when the semiconductor device operates will transfer to the bubbles through the sealant constituting the sealing part. This causes the temperature of the gas in the bubbles to fluctuate as the semiconductor element is turned on/off. Hence, the bubbles may thermally expand and shrink, thus allowing a current to leak, thereby lowering the reliability of the semiconductor device.

It is therefore an object of the present invention to provide a semiconductor device which can improve its reliability and a method for manufacturing the same.

### Solution to Problem

The semiconductor device in accordance with one aspect of the present invention comprises a semiconductor element; a substrate for mounting the semiconductor element; a case for containing the substrate mounted with the semiconductor element, the case allowing a sealant to be injected therein for sealing the semiconductor element; and a sealant injection path, formed in the case, for injecting the sealant into the case; while, in the sealant injection path, an injection port for the sealant into the case is located on the substrate side of an injection region of the sealant within the case.

### Advantageous Effects of Invention

The present invention can improve the reliability of the semiconductor device.

### Brief Description of Drawings

Fig. 1 is a sectional view schematically illustrating a semiconductor device in accordance with an embodiment;
Fig. 2 is a plan view schematically illustrating a case of the semiconductor device in accordance with the embodiment;
Fig. 3 is a flowchart illustrating a method for manufacturing a semiconductor device in accordance with an embodiment;
Fig. 4 is a diagram illustrating a step of injecting a sealant in the semiconductor device in accordance with the embodiment;
Fig. 5 is a sectional view schematically illustrating a first modified example of the case of the semiconductor device;
Fig. 6 is a plan view schematically illustrating the first modified example of the case of the semiconductor device;
Fig. 7 is a sectional view schematically illustrating a second modified example of the case of the semiconductor device; and
Fig. 8 is a plan view schematically illustrating the second modified example of the case of the semiconductor device.

### Description of Embodiments

### Explanation of embodiments of the present invention

First, embodiments of the present invention will be listed and explained.

The semiconductor device in accordance with one aspect of the present invention comprises a semiconductor element; a substrate for mounting the semiconductor element; a case for containing the substrate mounted with the semiconductor element, the case allowing a sealant to be injected therein for sealing the semiconductor element; and a sealant injection path, formed in the case, for injecting the sealant into the case; while, in the sealant injection path, an injection port for the sealant into the case is located on the substrate side of an injection region of the sealant within the case.

In this structure, the sealant is injected from the injection port of the sealant located on the substrate side in the injection region of the sealant within the case. Therefore, air is pushed out from the substrate side of the case to the side opposite from the substrate. This prevents bubbles from being included in a sealing part constructed by the sealant injected in the injection region or reduces their influences, thereby making it possible to improve the reliability of the semiconductor device.

In one embodiment, an inlet for the sealant into the sealant injection path may be located on the side opposite from the substrate in a thickness direction of the substrate.

In this configuration, the inlet for the sealant is located on the side opposite from the substrate in the case. When manufacturing the semiconductor device, the sealant is typically injected in the state where the substrate side is located lower in the vertical direction. Hence, at the time of injecting the sealant, the inlet for the sealant is located higher and makes it easier to put the sealant into the inlet.

In one embodiment, the inlet may be located on the outside of the injection region in the thickness direction of the substrate.

In this configuration, the inlet is located on the outside of the injection region in the thickness direction of the substrate. Therefore, at the time of injecting the sealant, the inlet for the sealant is located higher than the injection region, so that the sealant is harder to flow out of the inlet even when the inlet is not closed.

In one embodiment, a plurality of such injection ports may be provided.

In this configuration, since a plurality of injection ports are provided, the sealant can be injected into the case in a short time.

In one embodiment, the case may have a quadrangular form in planar view, the injection port being located at at least one of four corners of the case.

In this configuration, the sealant can be injected from the corner, thus making it harder for bubbles to be included at the corner in the sealing part constructed by the sealant and reducing their influences.

In one embodiment, the injection port may be formed into a slit extending unidirectionally.

In this configuration, the sealant can be injected uniformly from the injection port extending like a slit, which makes it possible to prevent bubbles from being included within the case or reduce their influences.

In one embodiment, a material for the semiconductor element may contain a wide-bandgap semiconductor.

A greater current can flow through a semiconductor element using a wide-bandgap semiconductor than a semiconductor element using silicon (Si). The semiconductor element using a wide-bandgap semiconductor may be used in an environment at a higher temperature than is the semiconductor element using silicon. Therefore, bubbles, if any, included within the sealing part constructed by the sealant tend to be more influential than in the semiconductor element using silicon. Hence, when the material for the semiconductor element contain a wide-bandgap semiconductor, advantageous effects of being able to prevent bubbles from being included within the case or of reducing their influences are exhibited more favorably.

The method for manufacturing a semiconductor device in accordance with one aspect of the present invention comprises the steps of mounting a semiconductor element to a substrate, containing the substrate in a case, and injecting a sealant into the case containing the substrate mounted with the semiconductor element; the case being formed with a sealant injection path for injecting the sealant into the case; in the sealant injection path, an injection port for the sealant into the case being located on the substrate side in an injection region of the sealant within the case; in the step of injecting the sealant, the sealant being injected into the injection region within the case through the sealant injection path.

In this structure, the sealant is injected from the injection port located on the substrate side within the case. Therefore, air is pushed out from the substrate side of the case to the side opposite from the substrate. This can prevent bubbles from being included within the case or reduce their influences.

In one embodiment, the step of injecting the sealant may be performed in a vacuum.

In this configuration, the surroundings of the semiconductor device are in a vacuum, which can more securely prevent bubbles from occurring within the case.

### Details of embodiments of the present invention

Specific examples of embodiments of the present invention will now be explained with reference to the drawings. In the explanation of the drawings, the same constituents will be referred to with the same signs while omitting their overlapping descriptions. Ratios of dimensions in the drawings do not always coincide with those explained. In the explanation, words indicating directions such as "upper" and "lower" are those for convenience based on their states illustrated in the drawings. The present invention is not limited to these illustrations, but intends to include all the changes within the meaning and scope equivalent to the claims.

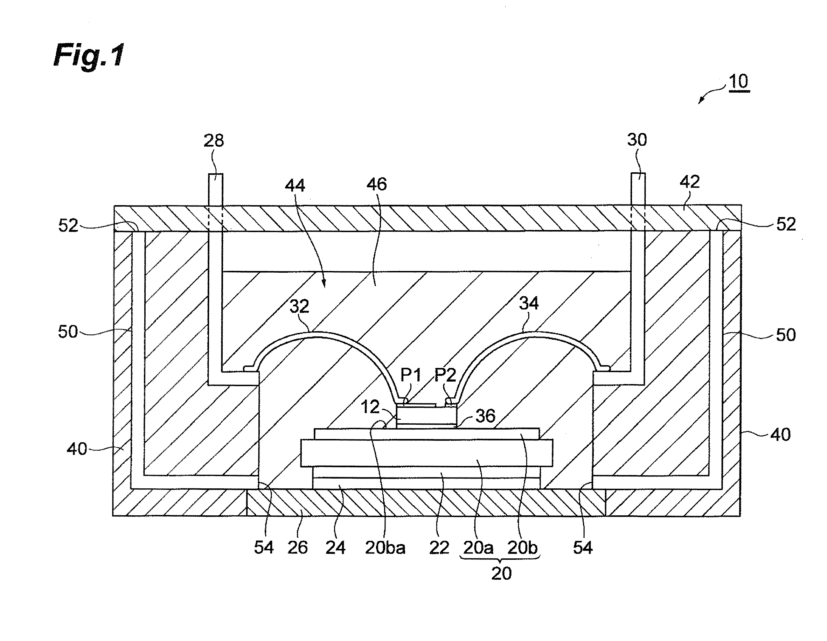

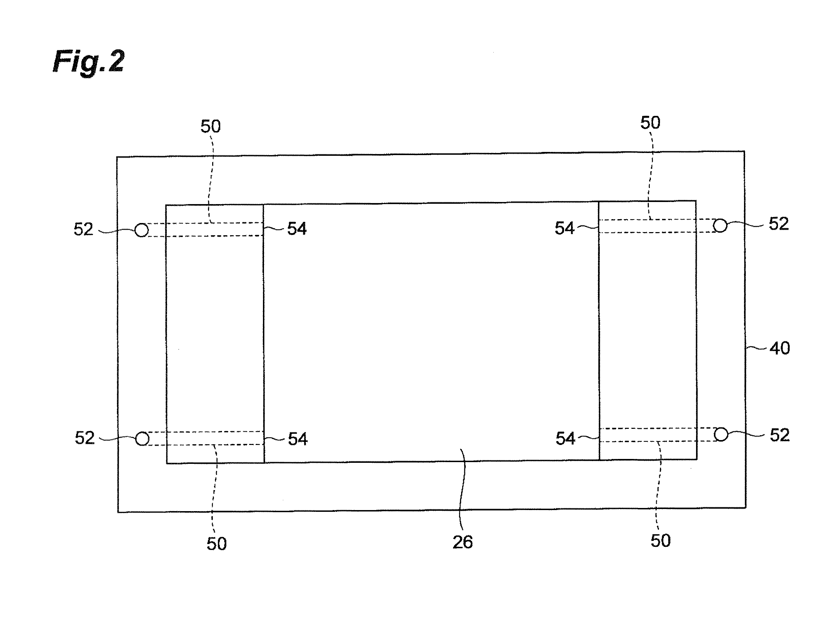

Fig. 1 is a sectional view schematically illustrating the semiconductor device in accordance with an embodiment. Fig. 2 is a plan view schematically illustrating a case of the semiconductor device in accordance with the embodiment. The semiconductor device 10 illustrated in Figs. 1 and 2 is a case-type semiconductor device. The semiconductor device 10 comprises a semiconductor element 12, a substrate 20, and a case 40.

The substrate 20 is a wiring board in which a wiring layer 20b is disposed on an insulating substrate 20a. A semiconductor element 12 is mounted on the substrate 20. Examples of materials for the insulating substrate 20a include ceramics. Examples of materials for the wiring layer 20b include metals such as copper and alloys of copper. The wiring layer 20b may have a predetermined wiring pattern. Examples of the semiconductor element 12 include transistors such as MOS-FET and insulated gate bipolar transistor (IGBT). Examples of materials for the semiconductor element 12 include wide-bandgap semiconductors and other semiconductors such as silicon. The wide-bandgap semiconductors have a bandgap greater than that of silicon. Examples of the wide-bandgap semiconductors include silicon carbide (SiC), gallium nitride (GaN), and diamond. When the semiconductor element 12 is made of SiC, the semiconductor device 10 tends to be used in a state where the semiconductor element 12 is at a high temperature (e.g., 200°C or higher).

The rear face of the substrate 20 (the surface on the side opposite from the side mounted with the semiconductor element 12) may be provided with a heat dissipation layer 22. Examples of materials for the heat dissipation layer 22 include metals such as copper and alloys of copper. The heat dissipation layer 22 is bonded to a heatsink 26 through a bonding layer 24 made of solder, for example. Examples of materials for the heatsink 26 include metals such as copper and alloys of copper as with the heat dissipation layer 22.

The semiconductor element 12 is equipped with electrode pads P1, P2 as upper electrodes. When the semiconductor element 12 is a MOS-FET, the electrode pads P1, P2 are source and gate electrodes, respectively. When the semiconductor element 12 is an IGBT, the electrode pads P1, P2 are emitter and gate electrodes, respectively. The electrode pad P1 is connected through a lead 32 to an electrode terminal 28 for external connection. The electrode pad P2 is connected through a lead 34 to an electrode terminal 30 for external connection. The semiconductor element 12 is equipped with a lower electrode on a surface opposite from the electrode pads P1, P2. When the semiconductor element 12 is the MOS-FET, the lower electrode is a drain electrode. When the semiconductor element 12 is the IGBT, the lower electrode is a collector electrode. The lower electrode of the semiconductor element 12 is mounted on an element mounting surface 20ba, which is the upper surface of the wiring layer 20b, with a bonding layer 36 interposed therebetween. Examples of materials for the bonding layer 36 include lead-containing metal solder, lead-free metal solder, and conductive resins. The lower electrode is connected through the wiring layer 20b to an undepicted electrode terminal for external connection.

The leads 32, 34 may be wires or ribbons. Examples of materials for the leads 32, 34 include metals such as aluminum, gold, and copper. The leads 32, 34 are connected to the electrode terminals 28, 30 and semiconductor element 12 by wire bonding using ultrasonic waves, pressures, and the like, for example.

The electrode terminals 28, 30 of the semiconductor device 10 are attached to an inner wall of the case 40, for example. The electrode terminals 28, 30 extend upward along the inner wall of the case 40. When the semiconductor element 12 is the MOS-FET, the electrode terminals 28, 30 correspond to source and gate electrode terminals, respectively. The electrode terminal corresponding to the drain electrode terminal is not depicted. When the semiconductor element 12 is the IGBT, the electrode terminals 28, 30 correspond to emitter and gate electrode terminals, respectively. The electrode terminal corresponding to the collector electrode terminal is not depicted. Fig. 1 illustrates a configuration in which the semiconductor element 12 is the MOS-FET.

The semiconductor element 12 and substrate 20 are contained in the case 40. The case 40 is tubular, for example. The case 40 is quadrangular in planar view. Fig. 2 illustrates a configuration in which the case 40 is rectangular in planar view. One opening of the case 40 may be sealed with the heatsink 26. The other opening of the case 40 may be sealed with a lid 42. The electrode terminals 28, 30 project out through apertures formed in the lid 42, for example. Examples of materials for the case 40 include resins such as engineering plastics typified by polybutylene terephthalate (PBT) and polyphenylene sulfide (PPS). Examples of materials for the lid 42 include thermoplastic resins. For stress relaxation, a gel (sealant) such as silicone gel, for example, may be injected into the case 40. The region to be injected with the gel within the case 40 will be referred to as injection region 44. Injecting the gel into the injection region 44 constructs a sealing part 46 constituted by the gel.

A sealant injection path 50 is formed in the case 40. The sealant injection path 50 is a passage for injecting the gel into the injection region 44 within the case 40. The sealant injection path 50 has an inlet 52 and an injection port 54. The inlet 52 is one opening of the sealant injection path 50 provided for injecting the gel into the sealant injection path 50. It is only necessary for the inlet 52 to be formed at such a position as to be able to inject the gel into the sealant injection path 50. The inlet 52 is formed in an outer surface of the case 40. In one embodiment, the inlet 52 is formed in the upper end face, which is a part of the outer surfaces of the case 40, as illustrated in Fig. 1, for example. Here, the substrate 20 is arranged on the lower side in the case 40. Therefore, the inlet 52 is located on the side opposite from the substrate 20 in the case 40.

The injection port 54 is the other opening of the sealant injection path 50. The injection port 54 is formed in an inner surface of the case 40 facing the injection region 44. The sealant injection path 50 extends through a wall part constituting the case 40 so as to connect the inlet 52 and the injection port 54 to each other. For example, as illustrated in Fig. 1, the sealant injection path 50 extends from the inlet 52 downward through the wall part constituting the case 40 and then bends horizontally on the bottom side of the case 40 toward the injection region 44, thereby reaching the injection port 54. It will be sufficient if at least one sealant injection path is provided. In one embodiment, a plurality of sealant injection paths 50 are provided. The sealant injection paths 50 are located one by one at four corners of the case in planar view, for example. The inlet 52 is located on the outer side in the vertical direction (the thickness direction of the substrate 20 in Fig. 1) than is the injection region 44. In other words, the injection port 52 is located higher than the surface of the sealing part 46 constituted by the gel injected into the case 40.

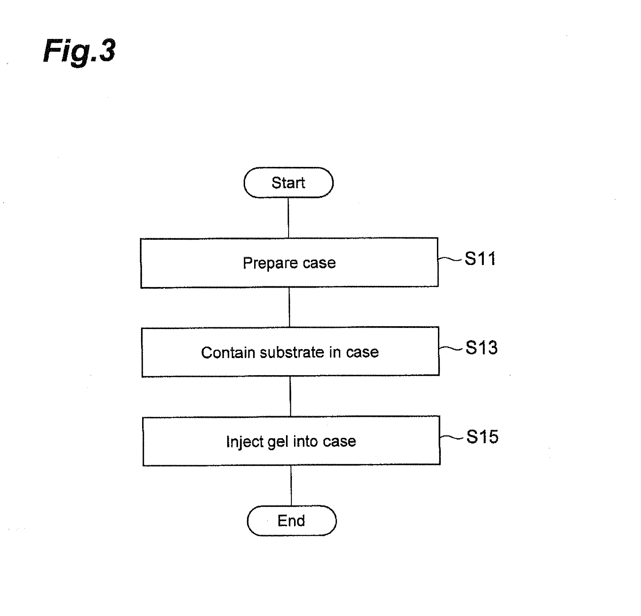

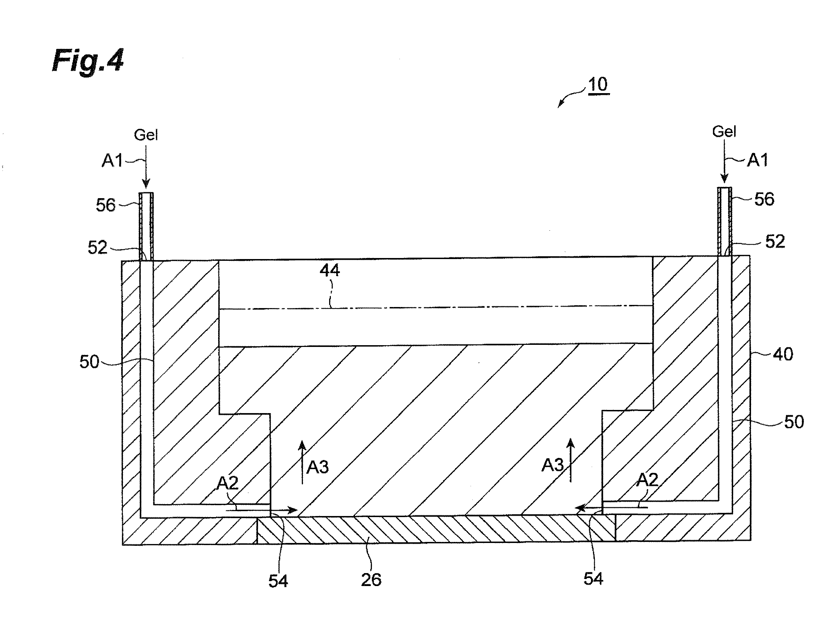

A method for manufacturing the semiconductor device 10 of one embodiment schematically illustrated in Fig. 1 will now be explained with reference to Figs. 3 and 4. Fig. 3 is a flowchart illustrating the method for manufacturing the semiconductor device 10, while Fig. 4 is a schematic view illustrating this method.

First, the case 40 is prepared (step S11). The case 40 prepared here is one for containing the substrate 20 mounted with the semiconductor element 12. The case 40 is formed with the sealant injection path 50 for injecting the gel for sealing the semiconductor element 12 to the inside of the case 40. The case 40 may be manufactured by molding, for example.

Subsequently, the semiconductor element 12 is mounted on the substrate 20. Then, the substrate 20 mounted with the semiconductor element 12 is contained in the case 40 (step S13). When the semiconductor device 10 is equipped with the heatsink 26, the substrate 20 is secured to the upper surface of the heatsink 26, and then the heatsink 26 is fixed to the case 40, whereby the substrate 20 is contained in the case 40. Thereafter, the electrode terminals 28, 30 are attached to the case 40. However, the electrode terminals 28, 30 may be attached to the case 40 before the case 40 is prepared at step S11. Then, the electrode pad P1 of the semiconductor element 12 and the electrode terminal 28 are connected to each other with the lead 32, and the wiring layer 20b of the substrate 20 and the electrode terminal 30 are connected to each other with the lead 34. The semiconductor element 12, substrate 20, electrode pad P1, electrode terminals 28, 30, and leads 32, 34 are not depicted in Fig. 4.

Next, the gel is injected into the case 40 (step S15). An example of methods for injecting the gel will now be explained. For example, as illustrated in Fig. 4, a tube 56 is connected to the inlet 52, and the gel is injected as indicated with an arrow A1 by using a syringe which is not depicted. The injected gel passes through the sealant injection path 50 and enters the injection region 44 from the injection port 54 as indicated with an arrow A2. As the gel is injected more, the liquid level of the gel rises as indicated with an arrow A3. The gel injection is ended when the liquid level of the gel reaches a predetermined height, i.e., the upper surface of the injection region 44. After the gel injection is ended, the lid 42 is attached to the case 40. This yields the semiconductor device 10. The step S 15 may be performed in a vacuum. When the step S 15 is performed in a vacuum, the surroundings of the semiconductor device 10 are in a vacuum, which can more securely prevent bubbles from occurring within the case 40.

The method for manufacturing a semiconductor device explained in the foregoing is just one example and can be changed as appropriate according to the structure of the semiconductor device.

In the semiconductor device 10 in accordance with one embodiment, as explained in the foregoing, the case 40 is formed with the sealant injection path 50, while the injection port 54 of the sealant injection path 50 is located on the substrate 20 side, whereby the gel can be injected from the substrate 20 side of the case 40. Therefore, air is pushed out from the substrate 20 side to the opposite side thereof. This prevents bubbles from being contained within the sealing part 46 constituted by the gel. Bubbles, if any, remaining within the sealing part 46 are less influential than those generated when the gel is directly injected into the case 40 from the upper opening thereof. Specifically, it reduces the number of bubbles or sizes of remaining bubbles. As a result, even when bubbles are thermally shrunk by the heat of the semiconductor element 12 generated when the semiconductor device 10 is driven, for example, current leakage at locations where bubbles remain, gel peeling from the inner wall of the case 40, and the like are hard to occur. Thus, bubbles do not remain within the sealing part 46 or if any with reduced influences, whereby the reliability of the semiconductor device 10 improves.

In the configuration where the inlet 52 for the gel is located on the side opposite from the substrate 20 in the case 40, since the gel is typically injected while the substrate 20 side is located lower in the vertical direction when manufacturing the semiconductor device 10, the injection port 52 for the gel is located higher than the inlet 54 at the time of injecting the gel. Therefore, it is easy for the gel to be put into the inlet 52 and injected through the sealant injection path 50.

In the configuration where the injection port 52 is located on the outside of the injection region 44 in the thickness direction of the substrate 20, the inlet 52 for the gel is located higher than the injection region 44 at the time of injecting the gel, whereby the gel is hard to flow out of the inlet 52 even without closing the inlet 52 when removing the tube 56 (see Fig. 4) from the inlet 52 immediately after completing the gel injection.

When a plurality of injection ports 54 are provided, the gel can be injected into the case 40 in a short time.

When the case 40 is quadrangular in planar view, while the injection port 54 is located at a corner of the case 40, the gel can be injected from the corner, so that the gel is securely injected into the corner where bubbles are likely to be contained and remain, whereby the bubbles are hard to be contained at the corner and become less influential.

When the semiconductor element 12 is one using a wide-bandgap semiconductor, a greater current can flow through the semiconductor element 12 than that using silicon (Si). Therefore, the semiconductor element 12 is used for power devices and the like. The semiconductor element 12 using a wide-bandgap semiconductor may be employed in an environment at a higher temperature than is that using silicon. Hence, bubbles, if any, existing within the sealing part 46 constructed by the gel tend to be more influential than in the semiconductor element using silicon. For example, bubbles are easy to migrate and may cause current leakage when moved to parts to be connected to the semiconductor element 12 and the like. Therefore, when the material for the semiconductor element 12 contain a wide-bandgap semiconductor, advantageous effects of this embodiment of being able to prevent bubbles from being included within the case or of reducing their influences are exhibited more favorably.

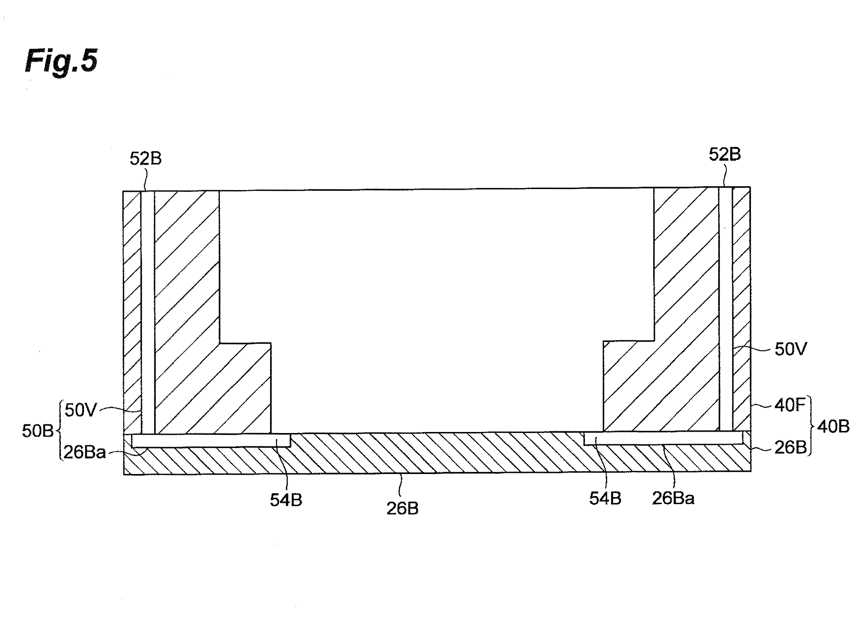

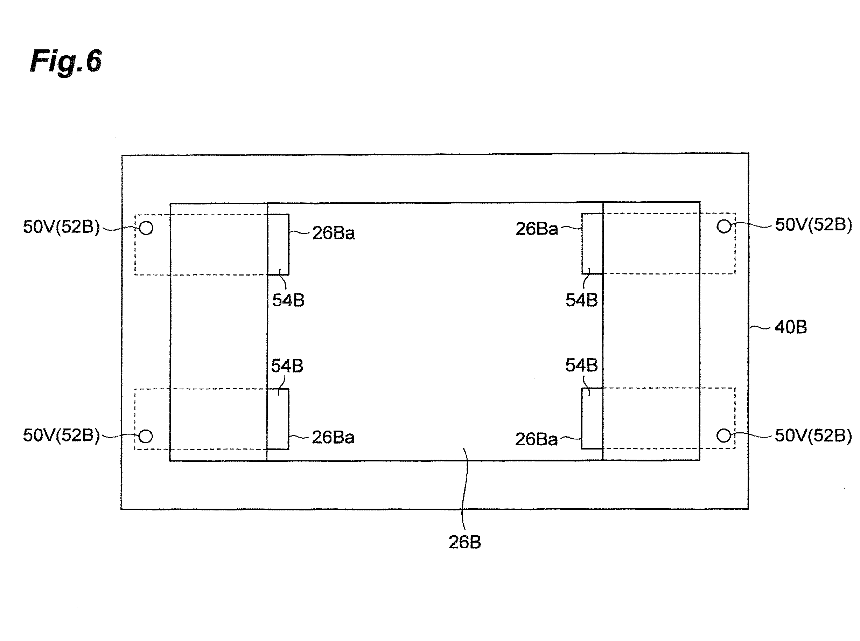

In the embodiment explained in the foregoing, the case 40 may be changed in various ways. Fig. 5 is a sectional view illustrating a case 40B of a first modified example. Fig. 6 is a plan view illustrating the case 40B of the first modified example.

The case 40B differs from the case 40 of the semiconductor device 10 in the following points. In the semiconductor device 10, the case 40 has an opening on the lower side, while the heatsink 26 closes the lower opening of the case 40. By contrast, the case 40B is constructed by combining a frame 40F and a heatsink 26B closing the lower opening of the frame 40F.

A hole 50V extends linearly in the vertical direction in the frame 40F. In the heatsink 26B, a depression 26Ba is provided at a position opposing the hole 50V. The hole 50V and the depression 26Ba continuous with the hole 50V form a sealant injection path 50B. An inlet 52B is provided in the upper part of the sealant injection path 50B, while an injection port 54B is located at a position facing the inside of the frame 40F in the depression 26Ba.

An example of methods for manufacturing the semiconductor device 10 equipped with the case 40B will now be explained. In the step of preparing the case, the frame 40F and the heatsink 26B may be prepared separately. In the step of containing the substrate in the case, for example, the substrate 20 is fixed to the upper surface of the heatsink 26B and then the frame 40F is secured to the upper surface of the heatsink 26B. Thus securing the frame 40F to the heatsink 26B having the substrate 20 fixed thereto forms the case 40B and lets the substrate 20 be contained within the case 40B. The step after containing the substrate 20 within the case 40B is the same as in the semiconductor device 10 equipped with the case 40.

The semiconductor device using the case 40B yields at least the same advantageous effects as with the semiconductor device 10. In addition, using the case 40B makes it possible for the hole 50V formed in the frame 40F in the sealant injection path 50B to have such a form as to extend linearly in the vertical direction, whereby the sealant injection path 50B can be formed more easily.

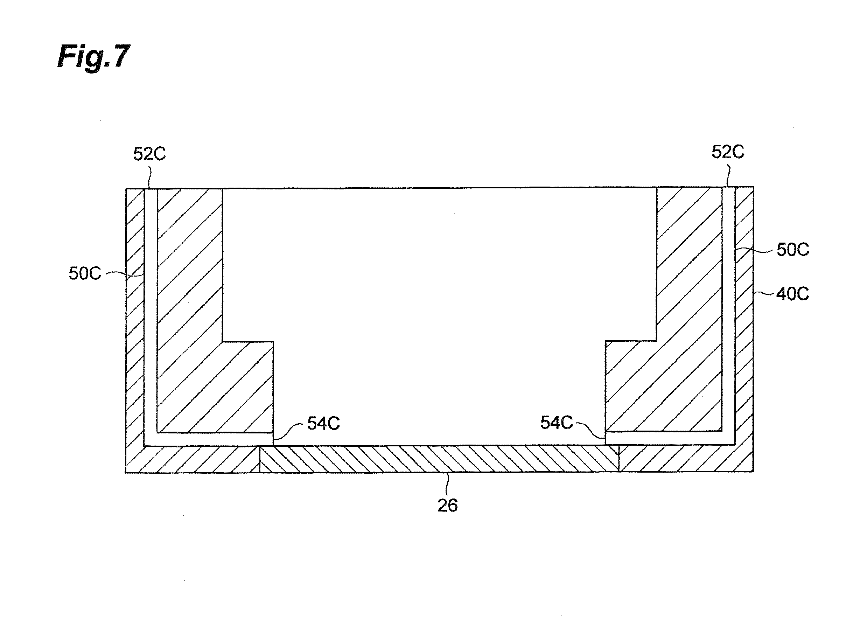

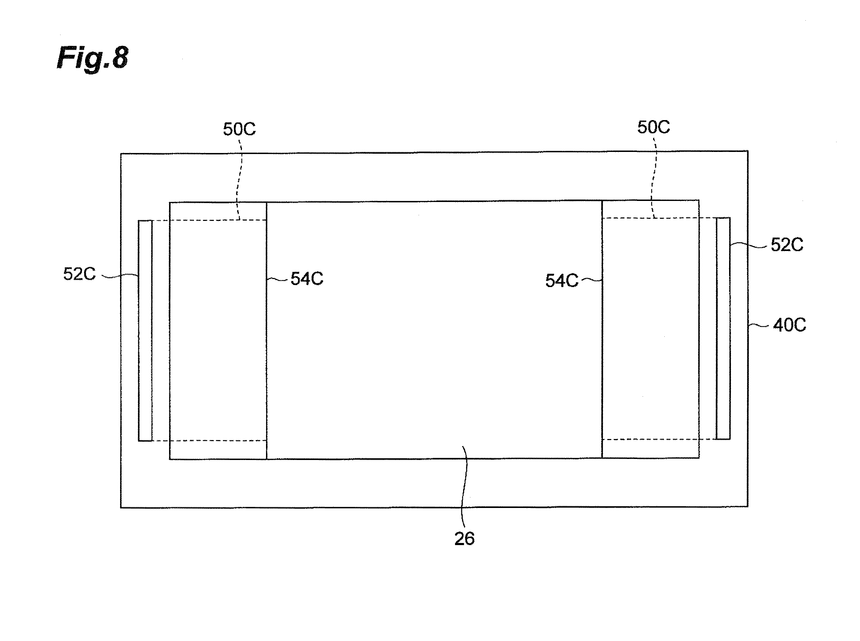

Fig. 7 is a sectional view illustrating a case 40C of a second modified example. Fig. 8 is a plan view illustrating the case 40C of the second modified example.

The case 40C differs from the case 40 illustrated in Fig. 1 in the form of the sealant injection paths 50. In the case 40 illustrated in Fig. 1, the sealant injection paths 50C are arranged at four corners of the case 40 in planar view and each have a circular cross section. In the case 40C, by contrast, an inlet 52 is formed like a slit extending unidirectionally along a shorter side in the periphery of the bottom part of the case 40C, while a sealant injection path 50C extends from the inlet 52C downward through a wall part constituting the case 40C. Then, the sealant injection path 50C bends horizontally on the bottom side of the case 40C toward the injection region 44, thereby reaching an injection port 54C. The injection port 54C is formed like a slit extending along the shorter side in the periphery of the bottom part of the case 40C.

The semiconductor device using the case 40C yields at least the same advantageous effects as with the semiconductor device 10. In addition, the semiconductor device using the case 40C can uniformly inject the gel from the injection port 54C extending like a slit, thereby making it possible to prevent bubbles from being contained within the sealing part 46 or reduce their influences.

While various embodiments of the present invention are explained in detail in the foregoing, the present invention is not limited to the above-mentioned embodiments but can be modified in various manners within the scope not departing from the gist of the present invention.

For example, the semiconductor device 10 may be equipped with two or more semiconductor elements instead of one. A diode or the like may be used in place of the transistor as the semiconductor element. In a case where the semiconductor device is equipped with a plurality of semiconductor elements, these elements may be a combination of a plurality of kinds of semiconductor elements such as transistors and diodes. Structures of electric connections of semiconductor elements in the semiconductor device 10 may be determined as appropriate according to the kinds of semiconductor elements.

The inlet 52 and injection port 54 may have forms different from each other. When the inlet 52 is shaped like a funnel so as to become wider on the upper side, for example, letting the gel flow into the funnel-like inlet 52 can inject the gel into the case 40, thereby making it faster and easier to inject the gel. In the mode forming a plurality of injection ports, it is not necessary for a plurality of sealant injection paths to be formed. For example, one sealant injection path may have one inlet and a plurality of injection ports and branch off from the inlet toward the discrete injection ports in the route therebetween.

The case 40, which is explained as having a tubular form, may be constructed by a tubular frame and a heatsink serving as a bottom plate as with the case 40B of the first modified example. The same holds for the case 40C of the second modified example. The semiconductor device 10 may be free of the lid 42.

The sealant is exemplified by a gel such as silicone gel, but may be any of thermosetting materials without being restricted to gels.

### Reference Signs List

10: semiconductor device; 12: semiconductor element; 20: substrate; 40, 40B, 40C: case; 44: injection region; 50: sealant injection path; 52, 52B, 52C: inlet; 54, 54B, 54C: injection port

## Claims

1. A semiconductor device comprising:
a semiconductor element;
a substrate for mounting the semiconductor element;
a case for containing the substrate mounted with the semiconductor element, the case allowing a sealant to be injected therein for sealing the semiconductor element; and
a sealant injection path, formed in the case, for injecting the sealant into the case;
wherein, in the sealant injection path, an injection port for the sealant into the case is located on the substrate side of an injection region of the sealant within the case.

2. The semiconductor device according to claim 1, wherein an inlet for the sealant into the sealant injection path is located on the side opposite from the substrate in a thickness direction of the substrate.

3. The semiconductor device according to claim 2, wherein the inlet is located on the outside of the injection region in the thickness direction of the substrate.

4. The semiconductor device according to any one of claims 1 to 3, wherein a plurality of such injection ports are provided.

5. The semiconductor device according to any one of claims 1 to 4, wherein the case has a quadrangular form in planar view; and
wherein the injection port is located at at least one of four corners of the case.

6. The semiconductor device according to any one of claims 1 to 4, wherein the injection port is formed into a slit extending unidirectionally.

7. The semiconductor device according to any one of claims 1 to 6, wherein a material for the semiconductor element contains a wide-bandgap semiconductor.

8. A method for manufacturing a semiconductor device comprising the steps of:
mounting a semiconductor element to a substrate;
containing the substrate in a case; and
injecting a sealant into the case containing the substrate mounted with the semiconductor element;
wherein the case is formed with a sealant injection path for injecting the sealant into the case;
wherein, in the sealant injection path, an injection port for the sealant into the case is located on the substrate side in an injection region of the sealant within the case; and
wherein, in the step of injecting the sealant, the sealant is injected into the injection region within the case through the sealant injection path.

9. The method for manufacturing a semiconductor device according to claim 8, wherein the step of injecting the sealant is performed in a vacuum.
